# EUROPÄISCHE PATENTSCHRIFT

(11) **EP 4 110 680 B1**
(45) Veröffentlichungstag und Bekanntmachung des Hinweises auf die Patenterteilung: **02.04.2025**
(21) Anmeldenummer: 21706888.1
(22) Anmeldetag: 18.02.2021
(51) Int. Cl.: B62D 5/04, H05K 7/14

(54) **ANTRIEBSEINHEIT EINER ELEKTRISCHEN HILFSKRAFTLENKUNG FÜR EIN KRAFTFAHRZEUG**
DRIVE UNIT OF AN ELECTRICAL POWER-ASSISTED STEERING SYSTEM FOR A MOTOR VEHICLE
UNITÉ D'ENTRAÎNEMENT D'UN SYSTÈME DE DIRECTION ASSISTÉE ÉLECTRIQUE POUR UN VÉHICULE AUTOMOBILE

(30) Priorität: 24.02.2020 DE 102020202340
(43) Veröffentlichungstag der Anmeldung: 04.01.2023
(73) Patentinhaber: thyssenkrupp Presta AG, 9492 Eschen (LI); thyssenkrupp AG, 45143 Essen (DE)
(72) Erfinder: DÜRIG, Manuel, 9470 Buchs SG (CH); GERNER, Raphael, 9492 Eschen (LI); HOUMPE TSAGUE, Brice, 9443 Widnau (CH); PFISTER, Thomas, 6840 Götzis (AT); SANDHOLZER, Julian, 6844 Altach (AT)
(74) Vertreter: thyssenkrupp Intellectual Property GmbH
(86) Internationale Anmeldenummer: PCT/EP2021/053932
(87) Internationale Veröffentlichungsnummer: WO 2021/170469

(56) Entgegenhaltungen:
- EP-A1- 1 955 927
- JP-A- 2013 106 376
- JP-A- 2016 146 702
- JP-A- 2018 125 948
- US-A1- 2014 125 173
- US-A1- 2015 222 156

## Beschreibung

### Stand der Technik

Die Erfindung betrifft eine Antriebseinheit für eine elektrische Hilfskraftlenkung eines Kraftfahrzeugs, umfassend einen Elektromotor mit einem Statorgehäuse, an dem ein Steuerungsgehäuse angebracht ist, in dem eine Steuerplatine angeordnet ist, und mit einer an dem Statorgehäuse angebrachten Verbindungseinheit, die elektrische Verbindungselemente und mindestens ein Positionierelement aufweist, wobei die Verbindungselemente an den Elektromotor und an die Steuerplatine elektrisch angeschlossen sind und das Positionierelement zur relativen Positionierung mit der Steuerplatine zusammenwirkt, wobei das Positionierelement zur relativen Positionierung mit dem Steuerungsgehäuse zusammenwirkt.

Im Stand der Technik sind Kraftfahrzeuglenkungen mit Hilfskraftunterstützung bekannt, bei denen zusätzlich zum Lenkmoment, welches vom Fahrer manuell auf das Lenkrad ausgeübt wird, durch eine elektro-mechanische Hilfskraftunterstützung zur Unterstützung und Entlastung des Fahrers eine Hilfskraft in den Lenkstrang eingebracht wird, und gegebenenfalls auch ein Zusatzlenkwinkel.

Die Hilfskraft wird mittels eines elektrischen Hilfskraftantriebs erzeugt, der eine Antriebseinheit mit einem elektrischen Motor aufweist, dessen Rotorwelle über ein Hilfskraftgetriebe mit dem Lenkstrang gekoppelt ist.

Eine gattungsgemäße Antriebseinheit ist im Stand der Technik beispielsweise aus der DE 10 2018 216 744 A1 bekannt. Diese umfasst einen Motor mit einem Statorgehäuse, in dem die Stator- oder Phasenwicklungen angebracht sind, und in dem der Rotor mit der in Achsrichtung liegenden Rotorwelle drehbar gelagert ist. Die elektrische Ansteuerung des Motors erfolgt durch eine elektrische Steuerschaltung, die auf einer Steuerplatine, auch als Leiterplatte oder PCB (printed circuit board) bezeichnet, angeordnete und verschaltete elektrische Bauelemente aufweist. Diese Steuerplatine ist in einem Steuergehäuse, auch als Steuerungs- oder Steuerplatinengehäuse bezeichnet, angeordnet, welches mit dem Statorgehäuse zu einer kompakten Baugruppe verbunden ist, die auch als Powerpack bezeichnet wird. Die elektrische und mechanische Verbindung zwischen den Phasenwicklungen des Motors und der Steuerplatine erfolgt über eine Verbindungseinheit. Diese ist einerseits an dem Statorgehäuse fixiert und an die Phasenwicklungen des Motors angeschlossen, und andererseits mit dem Steuergehäuse verbunden und an die Steuerplatine angeschlossen.

Bei der bekannten Antriebseinheit weist die Verbindungseinheit Positionierelemente in Form von Positionierstiften auf, die in korrespondierende Aufnahmeöffnungen in der Steuerplatine formschlüssig eingreifen. Dadurch wirken die Positionierelemente mit der Steuerplatine derart zusammen, so dass eine Positionierung und Ausrichtung der Steuerplatine relativ zur Verbindungseinheit, und damit zum Statorgehäuse erzeugt wird. Die Steuerplatine ist im montierten Zustand in dem Steuergehäuse geschützt untergebracht. Nachteilig ist dabei jedoch, dass das Steuergehäuse nicht oder nur unzureichend relativ zur Steuerplatine ausgerichtet ist. Das Steuergehäuse ist nämlich seinerseits an dem Statorgehäuse oder der Verbindungseinheit befestigt. Dadurch, dass sich bezüglich der Ausrichtung der Steuerplatine relativ zum Steuergehäuse die Toleranzen der Verbindungen zwischen Statorgehäuse, Verbindungseinheit und Steuerplatine addieren, kann die Montage der Steuerplatine erschwert werden, und es besteht ein erhöhtes Risiko von Beschädigungen bei der Montage.

Eine Antriebseinheit der eingangs genannten Art ist im Stand der Technik beispielsweise aus JP 2013 106376 A, JP 2018 125948 A, US 2015/222156 A1, US 2014/125173 A1 oder EP 1 955 927 A1 bekannt. Nachteilig an sämtlichen darin beschriebenen Ausführungen ist, dass die Montage umständlich ist.

Angesichts der vorangehend erläuterten Problematik ist es eine Aufgabe der vorliegenden Erfindung, eine einfachere und sicherere Montage einer Antriebseinheit zu ermöglichen.

### Darstellung der Erfindung

Diese Aufgabe wird erfindungsgemäß gelöst durch die Antriebseinheit mit den Merkmalen des Anspruchs 1. Vorteilhafte Weiterbildungen ergeben sich aus den Unteransprüchen.

Bei einer Antriebseinheit für eine elektrische Hilfskraftlenkung eines Kraftfahrzeugs, umfassend einen Elektromotor mit einem Statorgehäuse, an dem ein Steuerungsgehäuse angebracht ist, in dem eine Steuerplatine angeordnet ist, und mit einer an dem Statorgehäuse angebrachten Verbindungseinheit, die elektrische Verbindungselemente und mindestens ein Positionierelement aufweist, wobei die Verbindungselemente an den Elektromotor und an die Steuerplatine elektrisch angeschlossen sind und das Positionierelement zur relativen Positionierung mit der Steuerplatine zusammenwirkt, wobei das Positionierelement zur relativen Positionierung mit dem Steuerungsgehäuse zusammenwirkt, ist erfindungsgemäß vorgesehen, dass mindestens ein Positionierelement relativ zu einem anderen Positionierelement von dem Statorgehäuse weiter vorsteht.

Gemäß der Erfindung ist somit das mindestens eine Positionierelement, welches weiter vorsteht, länger als das oder die übrigen Positionierelemente, oder als das oder die Verbindungselemente. Das längere Positionierelement ist vorzugsweise mindestens 1mm länger oder mindestens 2mm länger als das andere Positionier-oder Verbindungselement. Dadurch, dass ein bevorzugt als Positionierstift ausgebildetes Positionierelement axial, in Achsrichtung weiter vorsteht, kann es in eine korrespondierende Positionieraufnahme, bevorzugt eine Aufnahmeöffnung, axial eingesetzt werden, wobei noch eine relative Orientierung des oder der übrigen, axial bezüglich der Montagerichtung weiter zurückliegenden Positionierelemente, die noch nicht in die korrespondierenden Positionieraufnahmen eingreifen, ermöglicht werden. Sobald ein, oder auch zwei vorstehende Positionierelemente formschlüssig in der definierten Einbaulage eingesetzt sind, sind die übrigen Positionierelemente automatisch bezüglich der korrespondierenden Positionieraufnahmen ausgerichtet und können durch weitere axiale Bewegung montiert werden. Dadurch kann die Montage vereinfacht werden.

Besonders bevorzugt ist der Elektromotor in dem Statorgehäuse angeordnet, welcher einen Stator mit Stator- oder Phasenwicklungen umfasst, in dem ein Rotor mit einer in Achsrichtung liegenden Rotorwelle drehbar gelagert ist.

Die Verbindungseinheit ist an dem Statorgehäuse positioniert und fixiert, und stellt mindestens ein erfindungsgemäßes Positionierelement, bevorzugt mehrere Positionierelemente bereit. Erfindungsgemäß ist das Positionierelement eingerichtet und ausgestaltet, um die positionsgenaue Ausrichtung sowohl der Steuerplatine als auch des Steuergehäuses relativ zur Verbindungseinheit zu ermöglichen. Mit anderen Worten sind die Steuerplatine und das Steuerungsgehäuse jeweils direkt an dem Positionierelement ausgerichtet, und damit parallel zueinander an demselben Positionierelement relativ zu der Verbindungseinheit positioniert und ausgerichtet, und nicht wie im Stand der Technik über eine serielle Anordnung von Verbindungen. Somit wird die im Stand der Technik unvermeidliche und potentiell schädliche Addition der Toleranzen der seriell angeordneten Verbindungen vermieden, und es wird eine verbesserte und präzisere Positionierung der Steuerplatine und des Steuergehäuses sichergestellt. Durch die verbesserte Maßhaltigkeit der Anordnung wird die Montage, insbesondere in der automatisierten Fertigung, vereinfacht. Die relative Orientierung zwischen dem Steuerungsgehäuse und dem Positionierelement ist weitestgehend unabhängig von Toleranzen, so dass durch die erfindungsgemäße Ausrichtung der Steuerplatine an diesem Positionierelement eine entsprechend genaue Ausrichtung der Steuerplatine relativ zum Steuerungsgehäuse gewährleistet ist. Durch diese reproduzierbare, toleranzarme Ausrichtung wird die Montage vereinfacht, und die Gefahr von Beschädigungen durch relative Fehlorientierungen beim Einsetzen der Steuerplatine in das Steuerungsgehäuse und beim Zusammenfügen der Verbindungen zwischen der Verbindungseinheit und der Steuerplatine verringert.

Die vorteilhaften Auswirkungen kommen insbesondere dadurch zustande, dass das oder die erfindungsgemäßen Positionierelemente erstmals eine gemeinsame Referenzposition zur Ausrichtung und Orientierung von Steuerungsgehäuse und Steuerplatine zur Verfügung stellen, wodurch toleranzbedingte Probleme und das Risiko von Beschädigungen bei der Montage verringert und weitgehend vermieden werden können.

Das Steuerungsgehäuse kann am Statorgehäuse fixiert sein, beispielsweise angeflanscht sein, beispielsweise mittels Befestigungsbolzen, die durch korrespondierende Befestigungsbohrungen hindurchgeführt und verschraubt sind. Durch ein hinreichend groß vorgegebenes Spiel kann die Fixierung in der durch die Positionierelemente definierten relativen Positionierung erfolgen. Das Steuerungsgehäuse kann beispielsweise stirnseitig bezüglich einer Achsrichtung, die durch die Rotorachse definiert ist, bevorzugt außen an dem Statorgehäuse festgelegt sein, beispielsweise durch eine Flanschverbindung. Alternativ oder zusätzlich können lösbare und/oder unlösbare Verbindungsmittel vorgesehen sein, zur Fixierung in der durch das oder die erfindungsgemäßen Positionierelemente vorgegebenen relativen Positionierung des Steuerungsgehäuses zur Verbindungseinheit und zum Statorgehäuse.

Die Ausrichtung und Fixierung der Steuerplatine kann an dem oder den erfindungsgemäßen Positionierelementen erfolgen, wenn das Steuerungsgehäuse relativ zu den Positionierelementen positioniert und fixiert ist. Dabei kann die Steuerungsplatine lösbar oder unlösbar mit mindestens einem Positionierelement verbunden sein, oder alternativ oder zusätzlich an dem Steuerungsgehäuse.

Die gleichzeitige Positionierung und Fixierung der Steuerplatine an einem Positionierelement hat den Vorteil einer rationellen Montage. Das oder die Positionierelemente können gleichzeitig als Befestigungselemente oder Verbindungelemente zwischen der Verbindungseinheit und der Steuerplatine und/oder dem Steuerungsgehäuse dienen. Die Fixierung kann lösbar oder unlösbar erfolgen, beispielsweise durch Löten, Kleben, Pressen, Verschrauben, Verklemmen oder dergleichen erfolgen. Dabei ist es denkbar und möglich, die Verbindung elektrisch leitfähig auszugestalten, und durch ein elektrisch leitfähiges Positionierelement eine elektrische Verbindung zwischen Verbindungseinheit und Steuerplatine zu erzeugen.

Dadurch kann der Fertigungs- und Montageaufwand reduziert werden. Somit sind die einen Positionierelemente als Phasenstecker des Elektromotors ausgebildet, während die anderen Positionierelemente der Positionierung dienen.

Das Steuerungsgehäuse kann nach außen über den Querschnitt des Statorgehäuses überstehen, beispielsweise seitlich quer zur Achsrichtung der Rotorachse. Dadurch ist es möglich, eine Steuerungsplatine einzusetzen, die größer ist als der im Innenquerschnitt des Statorgehäuses zur Verfügung stehende Einbauraum. Dies ermöglicht weiterhin eine verbesserte Kühlung der auf der Steuerplatine angebrachten elektronischen Komponenten. Dies sind weitere Vorteile gegenüber dem Stand der Technik, bei dem die Steuerplatine zusammen mit dem Steuerungsgehäuse innerhalb des Statorgehäuses angeordnet ist, wodurch der Einbauraum und die Möglichkeiten der Wärmeabfuhr eingeschränkt sein können.

Es kann vorgesehen sein, dass mindestens ein Positionierelement formschlüssig in eine korrespondierende Positionieraufnahme in dem Steuergehäuse eingreift. Die Positionieraufnahme kann dazu beispielsweise eine Ausnehmung oder eine bevorzugt in Achsrichtung durchgehende Durchgangsöffnung aufweisen, in welche das Positionierelement in einer Montagerichtung eingesetzt werden kann, zur Ausbildung eines Formschlusses. Die Montagerichtung kann bevorzugt der Achsrichtung entsprechen, und der Formschluss kann in dieser Richtung und/oder quer dazu wirksam sein. Das oder die Positionierelemente können ebenfalls in korrespondierende Positionieraufnahmen in der Steuerplatine eingreifen, beispielsweise formschlüssig in Ausnehmungen oder Durchgangsöffnungen.

Eine mit geringem Aufwand realisierbare und effektive Ausführung ist, dass mindestens ein Positionierelement einen in einer Achsrichtung des Motors ausgerichteten Positionierstift aufweist. Die Verbindungseinheit kann bevorzugt an dem Statorgehäuse derart angebracht sein, dass ein oder mehrere Positionierstifte stirnseitig axial vorstehen. Die damit korrespondierenden Positionieraufnahmen in dem Steuerungsgehäuse und der Steuerplatine können einfach als Öffnungen oder Ausnehmungen ausgebildet sein, in denen der Positionierstift einfach durch axiales Einstecken aufnehmbar ist. Bevorzugt kann eine axial durchgehende Durchgangsöffnung vorgesehen sein, beispielsweise in dem Steuerungsgehäuse, durch welche ein Positionierstift in Achsrichtung hindurch steckbar ist. Auf einem axial aus der Durchgangsöffnung des Steuerungsgehäuses vorstehenden Abschnitt eines Positionierstifts, einem Positionierabschnitt, kann die Steuerplatine mit einer korrespondierenden Positionieraufnahme, ebenfalls einer Ausnehmung oder Öffnung, positioniert und gegebenenfalls fixert werden. Eine derartige Anordnung von Positionierstiften und korrespondierenden Positionieraufnahmen ist mit geringem Aufwand darstellbar und ermöglich eine einfache und sichere Montage. Bei der Montage kann zuerst das Steuerungsgehäuse auf den oder die Positionierstifte aufgesteckt werden, und anschließend die Steuerplatine.

Ein Positionierstift kann einen kreisrunden, oder einen unrunden, wie beispielsweise einen mehreckigen oder anders geformten Querschnitt haben, der mit einem Innenquerschnitt einer Aufnahmeöffnung einer Positionieraufnahme korrespondiert. Dadurch kann ein einfaches Einsetzen in Achsrichtung ermöglicht werden, was einer axialen Montagerichtung entspricht. Durch eine entsprechende Anpassung von Form und Abmessungen kann ein Formschluss quer zur Montagerichtung erzeugt werden. Gegebenenfalls kann auch ein definiertes Spiel vorgesehen sein, beispielsweise durch Ausbildung eines Langloches oder Schlitzes, wodurch Toleranzen in einer Richtung ausgeglichen werden können, welche sich nicht negativ auf die erfindungsgemäße relative Ausrichtung von Steuerungsgehäuse und Steuerplatine auswirkt.

Es kann vorgesehen sein, dass mindestens ein Positionierelement mindestens einen ersten Positionierabschnitt zum Eingriff in das Steuerungsgehäuse und mindestens einen zweiten Positionierabschnitt zum Eingriff in die Steuerplatine aufweist. Der erste Positionierabschnitt kann beispielsweise einen größeren Querschnitt haben als der zweite Positionierabschnitt, beispielsweise bei einem Positionierstift einen größeren Durchmesser. Es kann beispielsweise ein in Achsrichtung gestufter Positionierstift ausgebildet sein. Das Steuerungsgehäuse kann mit einer als Durchgangsöffnung ausgebildeten Positionieraufnahme in axialer Montagerichtung über den zweiten Positionierabschnitt hinweg formschlüssig auf den ersten Positionierabschnitt aufgesteckt werden. Im fertigen Montagezustand, wenn das Steuerungsgehäuse auf dem ersten Positionierabschnitt sitzt und fixiert ist, steht der zweite Montageabschnitt axial aus dem Steuerungsgehäuse vor. Auf diesem vorstehenden zweiten Positionierabschnitt kann nun in axialer Montagerichtung die Steuerplatine aufgesteckt werden, bis der zweite Positionierabschnitt formschlüssig in der korrespondierenden Positionieraufnahme der Steuerplatine sitzt. Dadurch kann die Steuerplatine relativ zum Positionierelement und damit gleichzeitig relativ zum Steuerungsgehäuse ausgerichtet werden.

Die Positionieraufnahmen des Steuerungsgehäuses und der Steuerplatine können für ein vereinfachtes Positionieren und Hindurchstecken des mindestens einen längeren und axial weiter hervorstehenden Positionierelements im Vergleich zu den übrigen Positionieraufnahmen unterschiedliche Durchmesser aufweisen.

Es ist möglich, dass mindestens ein Positionierelement ein Verbindungselement aufweist. Dadurch kann ein Verbindungselement mit einem Positionierelement integriert ausgebildet sein. Beispielsweise kann ein Verbindungs- oder Kontaktelement einen Positionierstift mit einem integrierten elektrischen Leiter aufweisen, beispielsweise aus einem metallischen Werkstoff. Das Kontaktelement kann beispielsweise als Kontaktstift aus einem Draht ausgebildet sein.

Es ist möglich, dass ein Verbindungselement zumindest abschnittweise eine Umhüllung aus nichtleitendem Material aufweist. Ein oder mehrere Verbindungselemente können beispielsweise jeweils einen Kontaktstift aufweisen, der zusätzlich auch einen Positionierabschnitt eines Positionierelements aufweisen kann oder als solcher dient. Ein oder mehrere derartige Verbindungselemente oder Kontaktstifte können beispielsweise durch eine Kunststoff-Umspritzung aus einem thermoplastischen, elektrisch isolierenden Kunststoff umhüllt sein. Auf diese Weise kann die Umhüllung ein oder mehrere isolierte Abschnitte aufweisen, die auch als Positionierabschnitte eins erfindungsgemäßen Positionierelements ausgebildet sein können.

Die Kontaktstifte können als vorzugsweise gebogene Drahtabschnitte bereitgestellt werden, welche axial in Richtung der Rotorachse aus dem Kunststoff vorstehende Positionierabschnitte aufweisen. An den bezüglich der Positionieranschnitten abgewandten Endbereichen können jeweils Verbindungsabschnitte vorgesehen sein zur leitenden Verbindung mit den Drahtenden der Phasenwicklungen. Die Verbindungsabschnitte können abgewinkelt sein, um den Prozess zur Montage und der Erzeugung einer leitenden Verbindung zu vereinfachen, beispielsweise durch Crimpen oder Verschweißen.

Zum Einbetten in den Verbbindungskörper können die fertig gebogenen Kontaktstifte in die Spritzgussform eingelegt und anschließend mit schmelzflüssigem Kunststoff umspritzt werden. Die Positionierabschnitte stehen dann als blanke Drahtabschnitte aus dem Kunststoff vor.

Eine vorteilhafte Weiterbildung kann vorsehen, dass eine Mehrzahl von Positionierelementen einstückig miteinander verbunden ausgebildet sind, bevorzugt als Kunststoff-Spritzgussteil. Dadurch kann fertigungstechnisch günstig und mit geringen Maßtoleranzen eine Verbindungseinheit einschließlich der Positionierelemente als Spritzgussteil, bevorzugt aus thermoplastischem Kunststoff, zur Verfügung gestellt werden. Eine vorteilhafte Weiterbildung kann vorsehen, dass ein oder mehrere Verbindungselemente, beispielsweise metallische Kontaktstifte, in das Kunststoff-Spritzgussteil der Verbindungseinheit eingebettet sind. Besonders vorteilhaft kann es dabei sein, ein Verbindungs- oder Kontaktelement in einem Positionierelement einzubetten. Durch diese Integration wird eine vorteilhafte Mehrfach-Funktionalität ermöglicht: Beispielsweise kann im Kunststoff-Spritzguss mit geringem Aufwand und hoher Genauigkeit ein gestufter Positionierstift wie oben beschrieben bereitgestellt werden, und es können mehrere derartige Positionierstifte mit einer Verbindungseinheit einstückig integriert werden.

Zur Montage der Verbindungseinheit an dem Statorgehäuse kann bevorzugt vorgesehen sein, dass korrespondierende Befestigungselemente vorgesehen sind, die lösbar oder unlösbar miteinander fixiert werden. Vorzugsweise sind die Befestigungselemente eingerichtet und ausgestaltet, so dass sie in einer axialen Montagerichtung zusammengefügt werden können, um anschließend fixiert zu werden. Beispielsweise können die Befestigungselemente Zapfen - sogenannte Bobbins - und korrespondierende Aufnahmeöffnungen aufweisen, welche formschlüssig zusammengefügt werden können. Eine unlösbare Verbindung kann mittels Schweißen, Kleben, Verstemmen, Nieten oder dergleichen rationell, sicher und maßgenau erfolgen.

Eine vorteilhafte Weiterbildung kann vorsehen, dass das Steuerungsgehäuse auf seiner dem Statorgehäuse abgewandten Seite mit einem Steuergehäusedeckel verschlossen ist, so dass die Elektronikbauteile der Steuerplatine und andere empfindliche Elemente des Motors gegen Schmutz und Feuchtigkeit geschützt sind.

Zur Montage einer erfindungsgemäßen Antriebseinheit wird zunächst ein Statorgehäuse bereitgestellt, in dem der Rotor des Elektromotors bereits betriebsbereit drehbar gelagert sein kann. An dem Statorgehäuse kann bevorzugt, wie oben beschrieben, stirnseitig in axialer Montagerichtung eine Verbindungseinheit fixiert werden. Beispielsweise können korrespondierende Befestigungselemente der Verbindungseinheit und des Statorgehäuses bevorzugt formschlüssig in axialer Montagerichtung zusammengesetzt und miteinander fixiert werden. Dadurch ist die Verbindungseinheit derart in Position relativ zum Statorgehäuse fixiert, dass das oder die erfindungsgemäßen Positionierelemente zur nachfolgenden Montage des Steuerungsgehäuses positioniert und ausgerichtet sind. Bevorzugt können die Positionierelemente mindestens einen stirnseitig axial vorstehenden Positionierstift aufweisen, vorzugsweise mehrere stiftförmige, langgestreckte Positionierstifte.

Anschließend erfolgt das Ausrichten des Steuerungsgehäuses an mindestens einem Positionierelement der Verbindungseinheit und Fixieren relativ zum Statorgehäuse. Beim Ausrichten werden eine oder mehrere Befestigungsaufnahmen, bevorzugt Durchgangsöffnungen, axial fluchtend vor den korrespondierenden Positionierelementen, bevorzugt Positionierstiften angeordnet. Durch eine axiale Montagebewegung wird das Steuerungsgehäuse auf die Verbindungseinheit in Achsrichtung aufgesteckt, bis die Positionierstifte in die korrespondierenden Positionieröffnungen bevorzugt formschlüssig eintauchen, und dabei bevorzugt auf korrespondierenden ersten Positionierabschnitten sitzen. Bevorzugt ragen dabei die Positionierelemente dabei mit zweiten Positionierabschnitten axial über das Steuerungsgehäuse vor. Dank der Erfindung sind diese zweiten Positionierabschnitte allein durch das einfache Aufstecken präzise relativ zum Steuerungsgehäuse positioniert.

Anschließend erfolgt das Ausrichten der Steuerplatine an dem Positionierelement und Fixieren relativ zu dem Statorgehäuse. Zum Ausrichten wird eine korrespondierende Positionieraufnahme, beispielsweise eine axiale Positionieröffnung in der Steuerplatine, axial fluchtend vor dem bevorzugt als Positionierstift ausgebildeten Positionierelement angeordnet. Anschließend wird die Steuerplatine in axialer Montagerichtung auf das Steuerungsgehäuse zu bewegt, bis es in dieses eingesetzt ist und besagte zweite Positionierabschnitte des oder der Positionierstifte formschlüssig in die korrespondierenden Positionieröffnungen der Steuerplatine eintauchen. Dadurch wird die Steuerplatine selbständig auf dem oder den Positionierelementen ausgerichtet, und damit gleichzeitig relativ zu dem Steuerungsgehäuse.

Danach kann die Fixierung der Steuerplatine lösbar oder unlösbar erfolgen, beispielsweise durch Löten, Kleben, Pressen, Verschrauben, Verklemmen oder dergleichen. Dabei ist es denkbar und möglich, die Verbindung elektrisch leitfähig auszugestalten. Bevorzugt kann die Steuerplatine an dem oder den Positionierelementen festgelegt werden. Durch die Fixierung der Steuerplatine kann gleichzeitig auch das bezüglich der Montagerichtung unterhalb der Steuerplatine angeordnete Steuerungsgehäuse an der Verbindungseinheit fixiert werden.

Die Verbindungseinheit ist bevorzugt über elektrische Verbindungelemente an die Statorwicklungen angeschlossen, und mittels Verbindungselementen an die Steuerplatine angeschlossen. Die Verbindungselemente können in die Positionierelemente integriert sein, und beispielsweise einen leitfähigen Stift aufweisen, der bevorzugt über eine elektrisch leitfähige Verbindung wie Löten oder dergleichen mit der Steuerplatine mechanisch und elektrisch verbunden ist.

Ein Vorteil des erfindungsgemäßen Verfahrens ist, dass bei der Montage des Steuerungsgehäuses das oder die Positionierelemente selbsttätig ausgerichtet sind, und die nachfolgende Montage der Steuerplatine auf diesem oder diesen Positionierelementen einfach und präzise erfolgen kann. Dadurch wird das Risiko von Beschädigungen bei der Montage verringert, insbesondere auch bei automatisierten Montageverfahren.

Bevorzugt kann die Verbindungseinheit an dem einen oder mehreren Befestigungselementen unlösbar befestigt werden, die relativ zum Statorgehäuse und/oder zur Verbindungseinheit in einer Achsrichtung des Statorgehäuses vorstehen. Die Achsrichtung ist durch die Rotorachse vorgegeben. Die Befestigungselemente können beispielsweise einen oder mehrere axial stirnseitig vorstehende Befestigungsstifte oder -vorsprünge oder sogenannte Bobbins umfassen, auf die die Verbindungseinheit mit korrespondierenden Befestigungsöffnungen axial aufgesteckt und fixiert wird, beispielsweise durch Vernieten, Pressen oder dergleichen. Durch formschlüssig zusammenwirkende Befestigungselemente kann eine genaue Ausrichtung der Verbindungseinheit relativ zum Statorgehäuse erfolgen.

Bevorzugt können die Positionierelemente mindestens einen in einer Achsrichtung erstreckten Positionierstift aufweisen, auf die das Steuerungsgehäuse und die Steuerplatine mit korrespondierenden Positionieraufnahmen in Achsrichtung aufgesteckt wird. Das axiale Aufstecken ermöglicht eine besonders einfache Montage. Als Positionieraufnahme können mit geringem Aufwand Aufnahmeöffnungen in der Steuerplatine und/oder dem Steuerungsgehäuse ausgebildet werden.

Bei der Montage kann vorgesehen sein, dass das Steuerungsgehäuse an einem ersten Positionierabschnitt des Positionierelements positioniert wird, und die Steuerplatine an einem zweiten Positionierabschnitt positioniert wird. Die Positionierung quer zur Montagerichtung kann einfach durch einen formschlüssigen Eingriff des jeweiligen Positionierabschnitts in eine korrespondierende Positionieraufnahme bzw. -öffnung erfolgen. Beispielsweise kann ein Positionierstift gestuft sein, und axial aufeinander folgende Positionierabschnitte mit unterschiedlichem Durchmesser und/oder Querschnitt haben. Dann kann zur Montage erst das Steuerungsgehäuse auf den ersten Positionierabschnitt axial aufgesteckt werden, und dann die Steuerplatine.

Die Steuerplatine kann an mindestens einem der Positionierelemente fixiert sein, beispielsweise durch eine unlösbare oder lösbare Verbindung. Dadurch kann gleichzeitig das Steuerungsgehäuse an dem Positionierstift fixiert sein.

Bevorzugt kann bei der Montage vorgesehen sein, dass elektrische Verbindungselemente der Verbindungseinheit mit korrespondierenden Anschlusselementen an dem Stator und der Steuerplatine elektrisch verbunden werden. Die elektrische Verbindung kann zusammen bzw. gleichzeitig mit der mechanischen Verbindung erzeugt werden, beispielsweise durch Löten, Quetschen oder dergleichen, oder auch durch lösbare Steckverbinder oder dergleichen.

Nach der Montage des Steuerungsgehäuses an dem Statorgehäuse und der Anbringung der Steuerplatine in dem Steuerungsgehäuse kann dieses durch Anbringung einer Abdeckung oder eines Steuergehäusedeckels geschlossen werden, so dass die Steuerplatine bevorzugt abgedichtet eingeschlossen ist.

An dem Verbindungskörper kann mindestens ein Sternpunktverbinder angebracht sein. Ein Sternpunktverbinder ist aus gut leitfähigem Material ausgebildet, beispielsweise aus Kupfer, und weist jeweils mindestens drei Kontaktelemente wie Kontaktlaschen oder -fahnen auf, die mit den sternpunktseitigen Enden der Wicklungsdrähte der drei Phasenwicklungen im Sternpunkt leitend verbindbar sind. Ein Sternpunktverbinder kann beispielsweise als Blech- oder Drahtformteil ausgebildet sein, und bevorzugt an dem Verbindungskörper der Verbindungseinheit vorzugsweise unlösbar angebracht sein, beispielsweise durch Verschweißen. Die Kontaktelemente können ebenfalls wie dargestellt an dem Sternpunktverbinder abgewinkelt sein und in Richtung der Rotorachse von der Verbindungseinheit vorstehen. Ein Vorteil ist, dass der Sternpunkt mit geringem Aufwand mit der Verbindungseinheit integriert sein kann, wodurch die Montage erleichtert und Bauraum eingespart werden kann.

### Beschreibung der Zeichnungen

Vorteilhafte Ausführungsformen der Erfindung werden im Folgenden anhand der Zeichnungen näher erläutert. Im Einzelnen zeigen:
- Figur 1: eine Hilfskraftlenkung für ein Kraftfahrzeug in einer schematischen perspektivischen Darstellung,
- Figur 2: eine Antriebseinheit einer Hilfskraftlenkung gemäß Figur 1,
- Figur 3: die Antriebseinheit gemäß Figur 2 in einer schematischen, in Achsrichtung auseinander gezogenen Darstellung,
- Figur 4: eine schematische Darstellung der Antriebseinheit gemäß Figur 2 oder 3 in einem ersten Montagezustand des erfindungsgemäßen Verfahrens,
- Figur 5: eine schematische Darstellung in einem zweiten, auf Figur 4 folgenden Montagezustand,
- Figur 6: eine schematische Darstellung in einem dritten, auf Figur 5 folgenden Montagezustand,
- Figur 7: eine seitliche Ansicht des in Figur 5 gezeigten Montagezustands,
- Figur 8: eine schematische Darstellung in einem vierten, auf Figur 6 folgenden Montagezustand,
- Figur 9: eine schematische Darstellung in einem fünften, auf Figur 8 folgenden Montagezustand,
- Figur 10: eine schematische Darstellung in einem sechsten, auf Figur 9 folgenden Montagezustand,
- Figur 11: eine schematische Darstellung im fertig montierten Endzustand wie in Figur 2,
- Figur 12: eine Verbindungseinheit einer Antriebseinheit gemäß Figuren 1 bis 11 in einer schematisch auseinander gezogenen Darstellung,
- Figur 13: eine schematische Darstellung der Antriebseinheit in einer zweiten Ausführungsform in einem ersten Montagezustand in einer Ansicht entsprechend Figur 8,
- Figur 14: die Antriebseinheit gemäß Figur 13 in einer Ansicht entsprechend Figur 5,
- Figur 15: die Antriebseinheit gemäß Figur 14 in einer Ansicht entsprechend Figur 4,
- Figur 16: eine Verbindungseinheit einer Antriebseinheit gemäß Figuren 13 bis 15 in einer schematischen perspektivischen Ansicht,
- Figur 17: die Verbindungseinheit gemäß Figur 16 in einer weiteren schematischen perspektivischen Ansicht ähnlich Figur 4,
- Figur 18: eine Verbindungseinheit einer Antriebseinheit gemäß Figuren 13 bis 17 in einer schematisch auseinander gezogenen Darstellung.

### Ausführungsformen der Erfindung

In den verschiedenen Figuren sind gleiche Teile stets mit den gleichen Bezugszeichen versehen und werden daher in der Regel auch jeweils nur einmal benannt bzw. erwähnt.

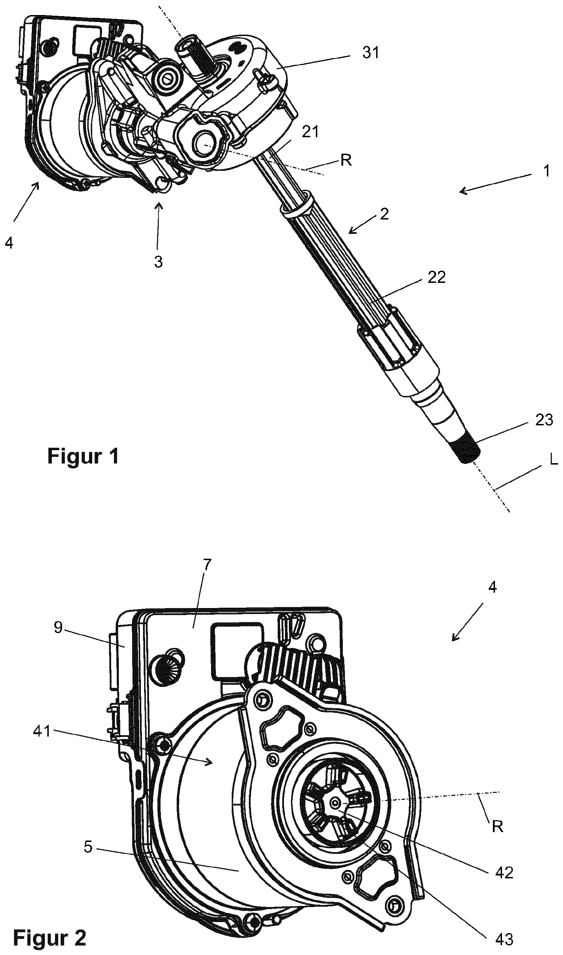

Figur 1 zeigt eine Hilfskraftlenkung 1, die an einer Lenkwelle 2 angebracht ist, welche um ihre Längsachse L, die Lenkwellenachse, drehbar gelagert ist. Die Lenkwelle 2 weist eine Innenwelle 21 auf, die drehmomentschlüssig und in Längsrichtung teleskopartig verstellbar in einer Außenwelle 22 angeordnet ist. An ihrem bezüglich der Fahrtrichtung hinteren Ende weist die Lenkwelle 2 einen Befestigungsabschnitt 23 zur Anbringung eines nicht dargestellten Lenkrads auf.

Ein elektrischer Hilfskraftantrieb 3 weist ein Getriebe 31 auf, bevorzugt ein Schneckengetriebe, dessen Ausgangsrad drehfest mit der Lenkwelle 2 gekuppelt ist, nämlich mit der Innenwelle 21.

Eingangsseitig ist an dem Getriebe 31 eine erfindungsgemäße Antriebseinheit 4 angebracht, die in Figur 2 separat in demontiertem Zustand gezeigt ist.

Die Antriebseinheit 4 weist einen elektrischen Motor 41 auf. Der Motor 41 weist ein Statorgehäuse 5 auf, in dem eine Rotorwelle 42 um eine Rotorachse R drehbar gelagert ist. Die Rotorachse R definiert die Achsrichtung der Antriebseinheit 4. Zur drehmomentschlüssigen Verbindung mit dem Getriebe 31 ist an der Rotorwelle 42 getriebeseitig eine Kupplung 43, welche in diesem Beispiel als Klauenkupplung ausgebildet sein kann, angebracht.

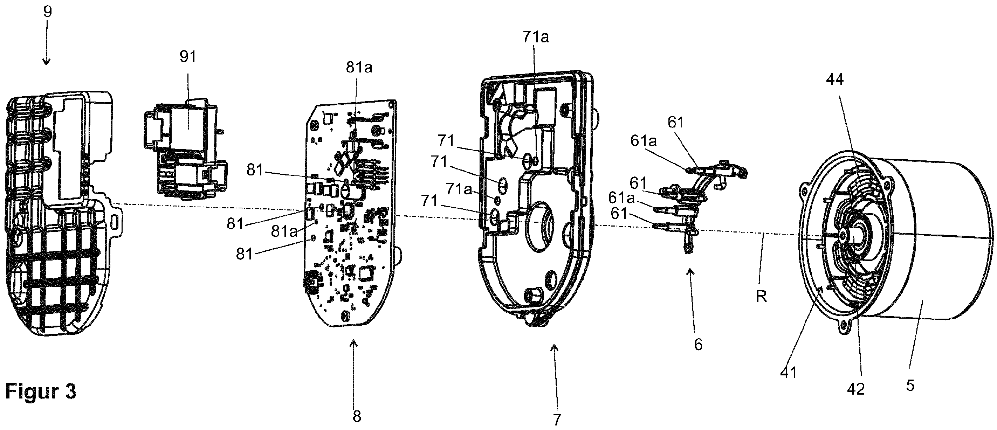

Figur 3 zeigt die Antriebseinheit 4 in einer Explosionsdarstellung, in der die einzelnen Komponenten in Achsrichtung der Rotorachse R auseinandergezogen dargestellt sind.

In dem Statorgehäuse 5 sind Phasenwicklungen 44 angebracht.

An dem Statorgehäuse 5 ist axial auf der dem Getriebe 31 abgewandten Seite eine Verbindungseinheit 6 angebracht, die als parallel axial vorstehende Positionierstifte 61 ausgebildete Positionierelemente aufweist.

Auf den Statorgehäuse 5 ist ein Steuerungsgehäuse 7 angebracht, welches über den Querschnitt des Statorgehäuses 5 quer zur Rotorachse R übersteht, und als Durchgangsöffnungen 71 ausgebildete Positionieraufnahmen aufweist, in welche die Positionierstifte 61 in Achsrichtung einsteckbar sind, und diese formschlüssig aufnehmen.

In einem dem Statorgehäuse 5 abgewandten Innenraum des Steuerungsgehäuses 7 ist eine Steuerplatine 8 angeordnet, auch als Leiterplatte oder PCB (printed circuit board) bezeichnet, auf der eine Steuerschaltung mit nicht näher bezeichneten elektronischen Bauelementen aufgebaut und verschaltet ist. Diese weist als Durchgangsöffnungen 81 ausgebildete Positioieraufnahmen auf, die mit den Positionieraufnahmen 71 der Verbindungseinheit 7 axial fluchten. Die Positionierstifte 61 sind ausgebildet, dass sie im montierten Zustand durch die Durchgangsöffnungen 71 hindurch aus dem Steuerungsgehäuse 7 axial vorstehen, und zur Montage axial in die Durchgangsöffnungen 81 der Steuerplatine 8 eingesteckt werden können.

Durch Anbringung eines Deckels 9 wird die Steuerplatine 8, dicht in dem Steuerungsgehäuse 7 eingeschlossen. Zwischen dem Deckel 9 und der Steuerplatine 8 ist ein Steckergehäuse 91 angebracht, in den ein nicht dargestellter elektrischer Verbinder einsteckbar ist zum Anschluss an Versorgungskontakte der Steuerplatine 7.

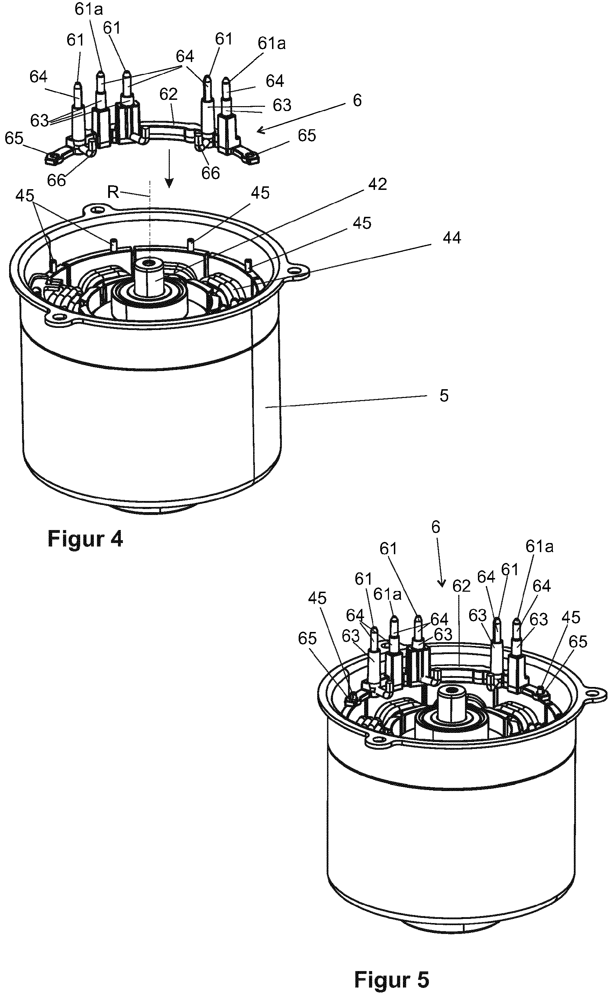

In den Figuren 4 bis 10 ist die Herstellung einer Antriebseinheit 1 gemäß dem erfindungsgemäßen Verfahren in aufeinander folgenden Montagezuständen gezeigt.

In Figur 4 ist erkennbar, dass die Verbindungseinheit 6 einen als Kunstsoff-Spritzgussteil ausgebildeten gemeinsamen Verbindungskörper 62 aufweist, von dem die Positionierstifte 61 axial abstehen. Die Positionierstifte 61 weisen einen ersten Positionierabschnitt 63 auf, der durch eine Kunststoff-Umspritzung von elektrisch leitenden Kontaktstiften gebildet wird, die aus einem gut leitfähigen metallischen Werkstoff bestehen. Die aus dem ersten Positionierabschnitt 63 axial vorstehenden Kontaktstifte 64 bilden zweite Positionierabschnitte 64, die einen kleineren Querschnitt haben als die ersten Positionierabschnitte 63. Die Positionierstifte 61 sind somit in axialer Richtung gestuft ausgebildet.

Der Verbindungskörper 62 weist axial durchgehende Befestigungsöffnungen 65 auf, die mit axial vorstehenden, stiftförmigen Befestigungsvorsprüngen 45 - sogenannten Bobbins - an dem Statorgehäuse 5 korrespondieren.

Ausgehend von dem in Figur 4 gezeigten Montagezustand wird die Verbindungseinheit 6 in Pfeilrichtung axial gegen das Statorgehäuse 5 bewegt, bis die Befestigungsvorsprünge 45 formschlüssig in die Befestigungsöffnungen 65 eintauchen, und dort durch Verstemmen, Vernieten, Verkleben oder dergleichen festgelegt werden so dass die Verbindungseinheit wie in Figur 5 gezeigt fixiert ist.

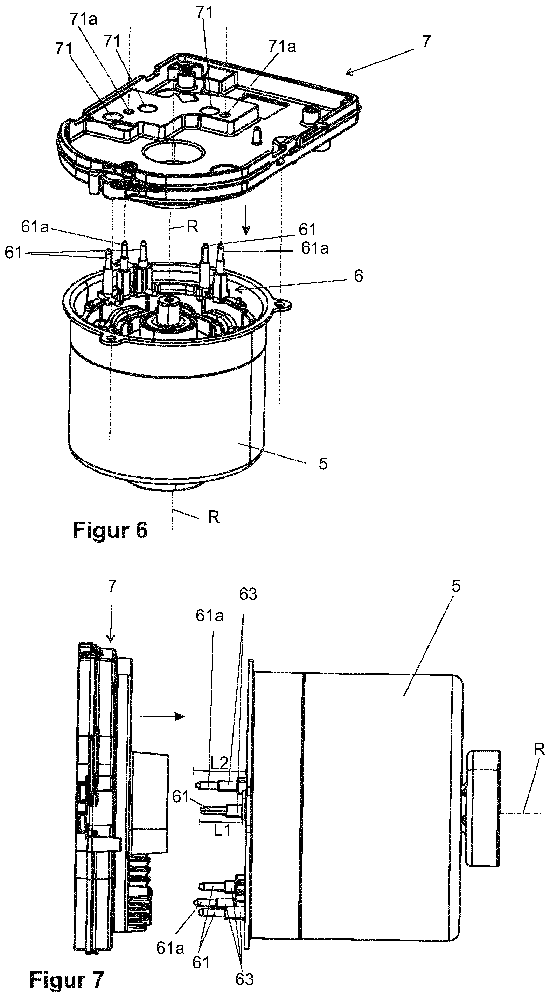

Im nächsten Schritt wird wie in Figuren 6 und 7 gezeigt das Steuerungsgehäuse 7 relativ zu dem Statorgehäuse 5 positioniert, so dass die Durchgangsöffnungen 71 mit den Positionierstiften 61 axial fluchten.

In der Seitenansicht quer zur Achsrichtung in Figur 7 ist gut erkennbar, dass im gezeigten Beispiel von den Positionierstiften 61 zwei Positionierstifte 61a axial weiter vorstehen als die Übrigen, die Positionierstifte 61a weisen eine Länge oder Höhe L2 auf, welche länger ist als die Länge L1 der Positionierstifte 61. Wird nun zur Montage das Steuerungsgehäuse 7 axial gegen das Statorgehäuse 5 bewegt, tauchen die Positionierstifte 61a zuerst in die zugehörigen Durchgangsöffnungen 71a ein, wodurch eine relative Orientierung und Ausrichtung des Steuerungsgehäuses 7 erfolgt, so dass das Einsetzen der übrigen Positionierstifte 61 in die zugehörigen Durchgangsöffnungen 71 gewährleistet ist. Die Durchgangsöffnungen 71, 71a des Steuerungsgehäuses 7 können für ein vereinfachtes Positionieren und Hindurchstecken der Positionierstifte 61,61a unterschiedliche Durchmesser aufweisen.

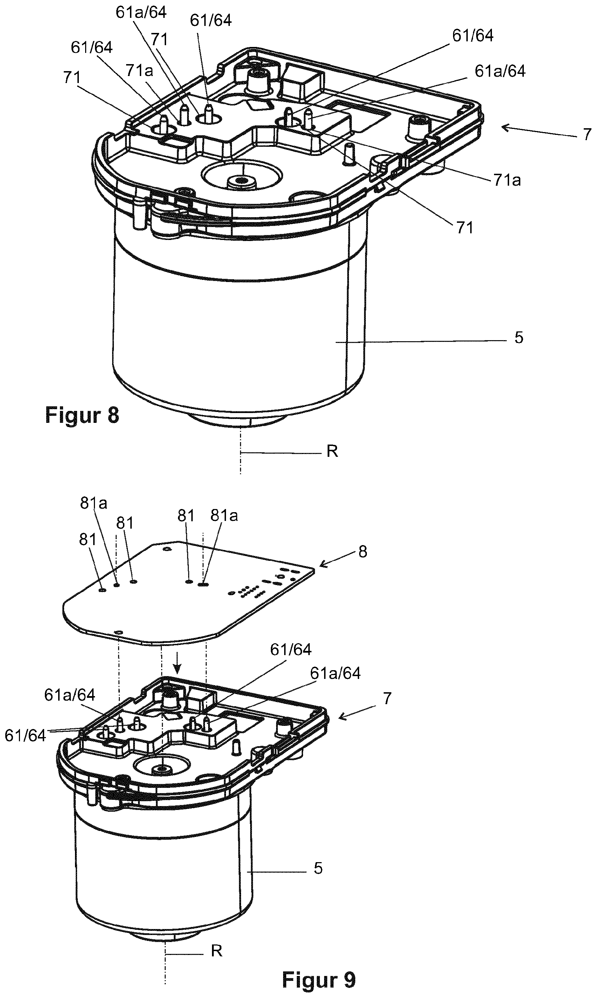

In dem in Figur 8 gezeigten Montagezustand ist das Steuerungsgehäuse 7 dadurch relativ zur Verbindungseinheit 6 und damit auch zum Statorgehäuse 5 positioniert, dass die Positionierstifte 61, 61a mit ihren ersten Positionierabschnitten 63 (siehe Figur 7) die DurchgangsÖffnungen 71,71a formschlüssig durchsetzen. Dabei stehen die zweiten Positionierabschnitte 64 der Positionierstifte 61, 61a axial aus dem Steuerungsgehäuse 7 vor.

Anschließend wird, wie in Figur 9 gezeigt, die Steuerplatine 8 axial relativ zum Steuerungsgehäuse 7 positioniert, so dass die Durchgangsöffnungen 81 axial mit den Positionierstiften 61 fluchten, nämlich mit den axial aus dem Steuerungsgehäuse 7 vorstehenden Positionierabschnitten 64.

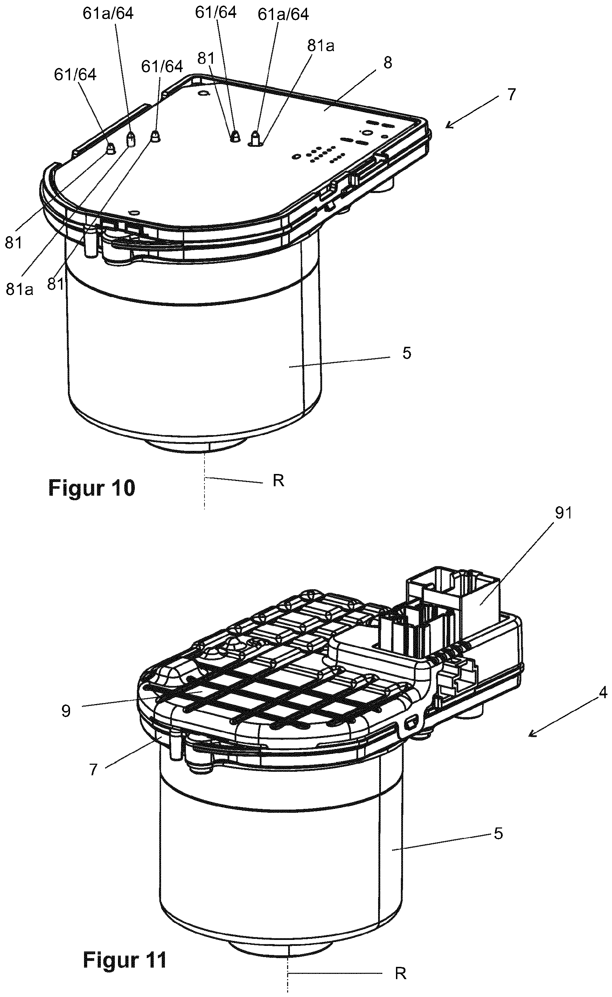

Daraufhin wird die Steuerplatine 8 in axialer Richtung auf das Steuerungsgehäuse 7 zu bewegt, bis zuerst die axial weiter vorstehenden Positionierstifte 61a durch die korrespondierenden Durchgangsöffnungen 81a hindurchgesteckt werden, und dann die übrigen Positionierstifte 61, bis der in Figur 10 gezeigte Montagezustand erreicht ist. Die Steuerplatine 8 befindet sich nun in dem Steuerungsgehäuse 7, und ist wie dieses an denselben Positionierstiften 61 quer zur Achsrichtung ausgerichtet. Dadurch, dass der Innendurchmesser der Durchgangsöffnungen 81 passgenau an den Durchmesser bzw. Querschnitt der zweiten Positionierabschnitte 64 angepasst ist, kann eine exakte Positionierung erzeugt werden. Um mechanische Überbestimmungen und Spannungszustände zu vermeiden, können einzelne oder mehrere der Durchgangsöffnungen 81,81a als Langlöcher ausgebildet sein, die in Querrichtung Spiel haben, wodurch die Ausrichtung der Steuerplatine 8 relativ zum Steuerungsgehäuse 7 jedoch nicht beeinträchtigt wird. Die Durchgangsöffnungen 81, 81a der Steuerplatine 8 können für ein vereinfachtes Positionieren und Hindurchstecken der Positionierstifte 61,61a unterschiedliche Durchmesser aufweisen.

In dem Montagezustand von Figur 10 sitzt die Steuerplatine 7 axial auf der zwischen den ersten Positionierabschnitten 63 und den zweiten Positionierabschnitten 64 gebildeten axialen Stufenfläche. Dadurch wird zusätzlich eine exakte axiale Positionierung der Steuerplatine 8 relativ zum Steuerungsgehäuse 7 ermöglicht. Die Positionierstifte 61,61a haben folglich eine Positionierwirkung gleichzeitig in und quer zur Achsrichtung.

Die vorstehenden Positionierabschnitte 64 können mit der Steuerplatine 8 verbunden werden, beispielsweise durch Löten. Dadurch wird zusätzlich zur mechanischen Positionierung und Fixierung eine leitfähige Verbindung zwischen den die zweiten Positionierabschnitte 64 aufweisenden Kontaktstiften und der auf der Steuerplatine 8 aufgebauten Steuerschaltung erzeugt.

Anschließend wird das Steuerungsgehäuse 7 durch axiale Anbringung des Deckels 9 verschlossen, so dass die Steuerplatine 8 darin eingeschlossen ist, wie in dem Endzustand der Montage in Figur 11, welcher dem Zustand von Figur 2 entspricht. Das Steckergehäuse 91 kann beispielsweise zwischen dem Deckel 9 und der Steuerplatine 8 geklemmt sein.

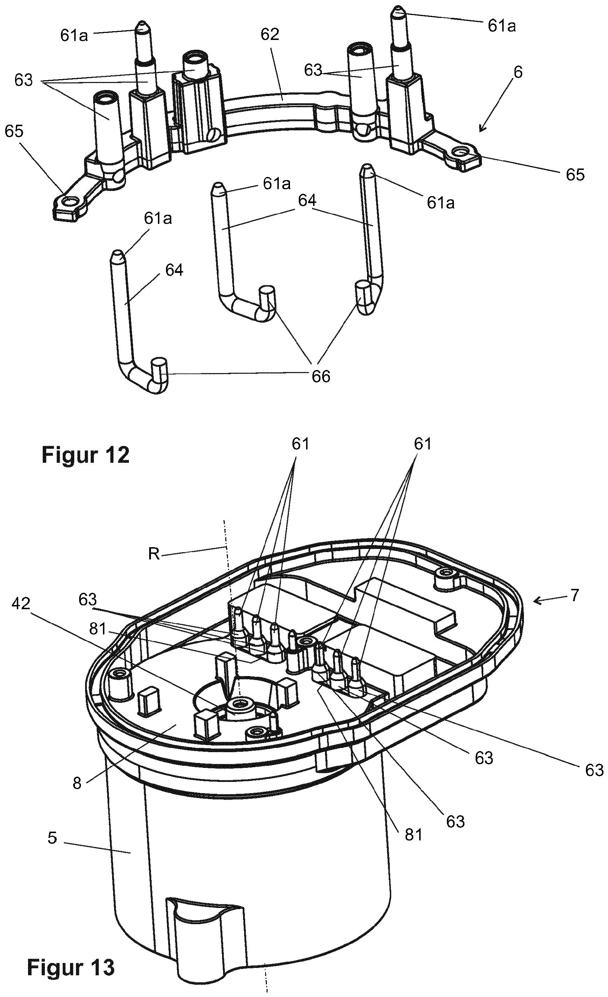

In der Figur 12 ist die Verbindungseinheit 6 schematisch auseinander gezogen dargestellt, wobei die zweiten Positionierabschnitte 64, die durch metallische, bevorzugt aus Draht ausgebildete Kontaktstifte 64 gebildet sind, von dem aus Kunststoff-Spritzguss geformten Verbindungskörper separat dargestellt sind. Darin sind deutlich die umgebogenen Verbindungsabschnitte 66 erkennbar, die im Wesentlichen in dieselbe Richtung (in der Zeichnung nach oben) weisen wie die Kontaktstifte 64, aber dabei deutlich kürzer sind. Diese Verbindungsabschnitte 66 können mit den Phasenwicklungen 44 leitend verbunden sein, beispielsweise durch Vercrimpen, Verpressen, Verlöten und/oder Verschweißen oder dergleichen mit den Enden des Wicklungsdrahtes dieser Phasenwicklungen 44.

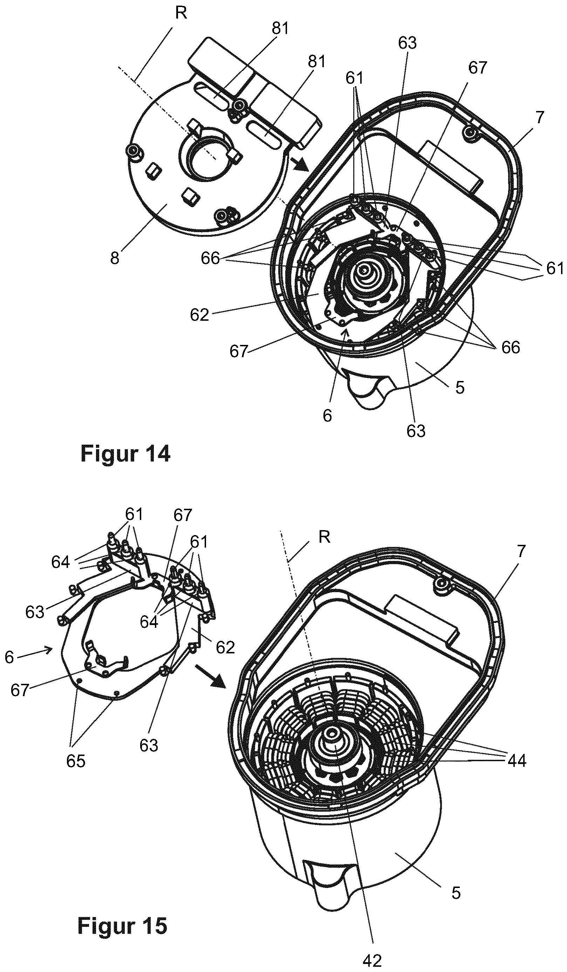

Die Figuren 13, 14 und 15 zeigen eine zweite Ausführungsform einer erfindungsgemäßen Antriebseinheit 4, wobei für gleichwirkende Teile dieselben Bezugszeichen verwendet werden. Die Ansicht von Figur 13 korrespondiert mit der Ansicht von Figur 8, Figur 14 mit Figur 9, und Figur 15 mit Figur 4 zusammen mit Figur 9.

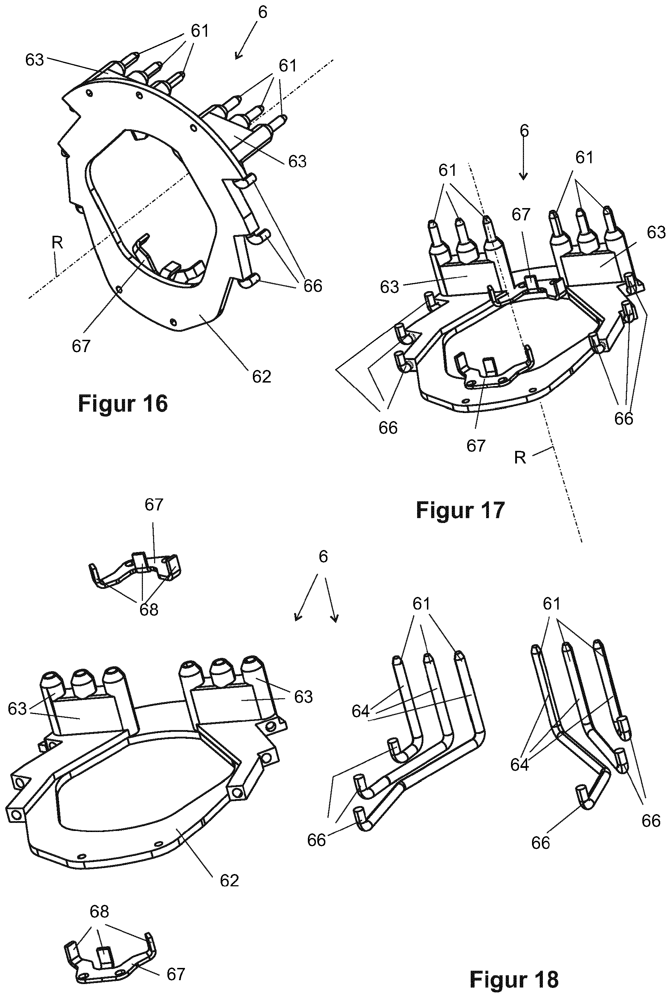

Die Verbindungseinheit 6 in der zweiten Ausführungsform in Figur 17 in einer perspektivischen Ansicht wie die erste Ausführung in Figur 4 gezeigt, und in Figur 16 in einer weiteren perspektivischen Ansicht. Figur 18 zeigt eine schematisch auseinander gezogene Darstellung ähnlich Figur 12.

Anhand der separaten Darstellung in Figuren 16 und 17 ist erkennbar, dass die Verbindungseinheit 6 einen flachen, bezüglich der Rotorachse R ringförmigen Verbindungskörper 62 hat, der ebenfalls bevorzugt als Kunststoff-Spritzgussteil ausgebildet sein kann. In den Verbindungskörper 62 sind aus Drahtabschnitten ausgebildete Kontaktstifte 64 - auch als zweite Positionierstifte bezeichnet - fest eingebettet, bevorzugt durch Umspritzen mit dem Kunststoff im Spritzgussverfahren. Die durch die Kontaktstifte 64 gebildeten, parallel zur Rotorachse R vorstehenden Endabschnitte der Kontaktstifte 64 bilden Positionierstifte 61. Dabei ist in Figur 17 gut erkennbar, dass alle Positionierstifte 61 von dem Verbindungskörper 62 gleich weit axial vorstehen.

Die Positionierstifte 61 sind durch Positionierabschnitte 63 hindurchgeführt, die einstückig mit dem Verbindungskörper 62 ausgebildet sind und von diesem axial in Richtung der Rotorachse R vorstehen,

An dem Verbindungskörper 62 sind zwei Sternpunktverbinder 67, die beispielsweise als Blechformteile ausgebildet sein können, bevorzugt unlösbar angebracht, beispielsweise durch Verschweißen. Die Sternpunktverbinder 67 sind aus gut leitfähigem Material ausgebildet, beispielsweise aus Kupfer, und weisen jeweils mindestens drei Kontaktlaschen 68 auf, die mit den sternpunktseitigen Enden der Wicklungsdrähte der drei Phasenwicklungen 44 im Sternpunkt leitend verbindbar sind, Die Kontaktlaschen 68 können ebenfalls wie dargestellt an dem Sternpunktverbinder abgewinkelt sein und in Richtung der Rotorachse R vorstehen.

Die Verbindungseinheit 6 wird axial in Richtung der Rotorachse R in das Statorgehäuse 5 eingesetzt, wie in Figur 15 mit dem Pfeil angedeutet. Die Rotorwelle 42 durchsetzt dabei zentral die Öffnung des ringförmigen Verbindungskörpers 62.

In der gezeigten zweiten Ausführung kann das Steuerungsgehäuse 7 bei der Montage der Verbindungseinheit 6 bereits an dem Statorgehäuse 5 angebracht sein. Ansonsten erfolgt die Montage wie oben zu Figur 4 und 5 erläutert. Wie dies im einzelnen erfolgt, ist oben im Zusammenhang mit Figur 3 erläutert.

Wenn die Verbindungseinheit 6 eingesetzt ist, wie in Figur 14 dargestellt, werden die Statorwicklungen 44 mit den Verbindungsabschnitten 66 der Kontaktstifte 64 und den Kontaktlaschen 68 der Sternpunktverbinder 67 verbunden.

Anschließend wird die Steuerplatine 8 in der durch die Rotorachse R vorgegebenen axialen Richtung in das Statorgehäuse 5 eingesetzt, wie in Figur 14 mit dem Pfeil angedeutet. Dabei gelangen die Positionierstifte 61 und die Positionierabschnitte 63 in Eingriff mit den Durchgangsöffnungen 81 in der Steuerplatine 8, wodurch diese positioniertfixiert wird.

Figur 18 zeigt eine schematisch auseinandergezogene Darstellung der Verbindungseinheit 6. Die durch Drahtabschnitte gebildeten Kontaktstifte 64 werden in den als Kunststoff-Spritzgussteil ausgebildeten Verbindungskörper 62 eingebettet, wie dies oben für die erste Ausführung in Figur 12 bereits beschrieben ist. Die Sternpunktverbinder 67 können ebenfalls an- oder eingespritzt werden, oder nachträglich angebracht werden.

### Bezugszeichenliste

- 1: Hilfskraftlenkung
- 2: Lenkwelle
- 21: Innenwelle
- 22: Außenwelle
- 23: Befestigungsabschnitt
- 3: Hilfskraftantrieb
- 31: Getriebe
- 4: Antriebseinheit
- 41: Motor
- 42: Rotorwelle
- 43: Kupplung
- 44: Phasenwicklung
- 45: Befestigungsvorsprünge
- 5: Statorgehäuse
- 6: Verbindungseinheit
- 61,61a: Positionierstifte
- 62: Verbindungskörper
- 63: erster Positionierabschnitt
- 64: zweiter Positionierabschnitt (Kontaktstift)
- 65: Befestigungsöffnungen
- 66: Verbindungsabschnitte
- 67: Sternpunktverbinder
- 68: Kontaktlaschen
- 7: Steuerungsgehäuse
- 71: Durchgangsöffnungen
- 8: Steuerplatine
- 81: Durchgangsöffnungen
- 9: Deckel
- 91: Steckergehäuse

- R: Rotorachse

## Patentansprüche

1. Antriebseinheit (4) für eine elektrische Hilfskraftlenkung (1) eines Kraftfahrzeugs, umfassend einen Elektromotor (41) mit einem Statorgehäuse (5), an dem ein Steuerungsgehäuse (7) angebracht ist, in dem eine Steuerplatine (8) angeordnet ist, und mit einer an dem Statorgehäuse (5) angebrachten Verbindungseinheit (6), die elektrische Verbindungselemente und mindestens ein Positionierelement (61) aufweist, wobei die Verbindungselemente an den Elektromotor (41) und an die Steuerplatine (8) elektrisch angeschlossen sind und das Positionierelement (61) zur relativen Positionierung mit der Steuerplatine (8) zusammenwirkt,
wobei das Positionierelement (61) zur relativen Positionierung mit dem Steuerungsgehäuse (7) zusammenwirkt,
**dadurch gekennzeichnet,**
**dass** mindestens ein Positionierelement (61a) relativ zu einem anderen Positionierelement (61a) von dem Statorgehäuse (5) weiter vorsteht.

2. Antriebseinheit nach Anspruch 1, **dadurch gekennzeichnet, dass** mindestens ein Positionierelement (61) formschlüssig in eine korrespondierende Positionieraufnahme (71) in dem Steuergehäuse (7) eingreift.

3. Antriebseinheit nach einem der vorangehenden Ansprüche, **dadurch gekennzeichnet, dass** mindestens ein Positionierelement (61) einen in einer Achsrichtung ausgerichteten Positionierstift (61) aufweist.

4. Antriebseinheit nach einem der vorangehenden Ansprüche, **dadurch gekennzeichnet, dass** mindestens ein Positionierelement (61) mindestens einen ersten Positionierabschnitt (63) zum Eingriff in das Steuerungsgehäuse (7) und mindestens einen zweiten Positionierabschnitt (64) zum Eingriff in die Steuerplatine (8) aufweist.

5. Antriebseinheit nach einem der vorangehenden Ansprüche, **dadurch gekennzeichnet, dass** mindestens ein Positionierelement (61) ein Verbindungselement aufweist.

6. Antriebseinheit nach einem der vorangehenden Ansprüche, **dadurch gekennzeichnet, dass** ein Verbindungselement zumindest abschnittweise eine Umhüllung aus nichtleitendem Material aufweist.

7. Antriebseinheit nach einem der vorangehenden Ansprüche, **dadurch gekennzeichnet, dass** das Steuerungsgehäuse (7) auf seiner dem Statorgehäuse (5) abgewandten Seite mit einem Steuergehäusedeckel (9) verschlossen ist.

## Claims

1. A drive unit (4) for an electrical power-assisted steering system (1) of a motor vehicle, comprising an electric motor (41) with a stator housing (5) to which a control housing (7), in which a control circuit board (8) is arranged, is attached, and with a connecting unit (6), attached to the stator housing (5), which has electrical connecting elements and at least one positioning element (61), wherein the connecting elements are electrically connected to the electric motor (41) and to the control circuit board (8), and the positioning element (61) interacts with the control circuit board (8) for the purpose of relative positioning, wherein the positioning element (61) interacts with the control housing (7) for the purpose of relative positioning,
**characterized in that**
at least one positioning element (61a) projects further from the stator housing (5) relative to another positioning element (61a).

2. **The** drive unit as claimed in claim 1, **characterized in that** at least one positioning element (61) engages in form-fitting fashion in a corresponding positioning socket (71) in the control housing (7).

3. **The** drive unit as claimed in one of the preceding claims, **characterized in that** at least one positioning element (61) has a positioning pin (61) which is aligned in an axial direction.

4. **The** drive unit as claimed in one of the preceding claims, **characterized in that** at least one positioning element (61) has at least one first positioning section (63) for engaging in the control housing (7) and at least one second positioning section (64) for engaging in the control circuit board (8).

5. The drive unit as claimed in one of the preceding claims, **characterized in that** at least one positioning element (61) has a connecting element.

6. The drive unit as claimed in one of the preceding claims, **characterized in that** a connecting element has a coating of non-conductive material at least in some places.

7. The drive unit as claimed in one of the preceding claims, **characterized in that** the control housing (7) is closed on its side remote from the stator housing (5) with a control housing lid (9).

## Revendications

1. Unité d'entraînement (4) pour un système de direction assistée électrique (1) d'un véhicule à moteur, comprenant un moteur électrique (41) avec un boîtier de stator (5) auquel est fixé un boîtier de commande (7) dans lequel est disposée une carte de circuit imprimé de commande (8), et avec une unité de connexion (6), fixée au boîtier de stator (5), qui comporte des éléments de connexion électriques et au moins un élément de positionnement (61), les éléments de connexion sont reliés électriquement au moteur électrique (41) et à la carte de circuit imprimé de commande (8), et l'élément de positionnement (61) interagit avec la carte de circuit imprimé de commande (8) à des fins de positionnement relatif, l'élément de positionnement (61) interagissant avec le boîtier de commande (7) à des fins de positionnement relatif,
**caractérisé par le fait que**
au moins un élément de positionnement (61a) dépasse du carter du stator (5) par rapport à un autre élément de positionnement (61a).

2. L'unité d'entraînement selon la revendication 1, **caractérisée par le fait qu'**au moins un élément de positionnement (61) s'engage de manière ajustée dans une prise de positionnement correspondante (71) dans le boîtier de commande (7).

3. L'unité d'entraînement selon l'une des revendications précédentes, **caractérisée par le fait qu'**au moins un élément de positionnement (61) possède une broche de positionnement (61) qui est alignée dans une direction axiale.

4. L'unité d'entraînement selon l'une des revendications précédentes, **caractérisée par le fait qu'**au moins un élément de positionnement (61) possède au moins une première section de positionnement (63) pour s'engager dans le boîtier de commande (7) et au moins une deuxième section de positionnement (64) pour s'engager dans la carte de circuit imprimé de commande (8).

5. L'unité d'entraînement selon l'une des revendications précédentes, **caractérisée par le fait qu'**au moins un élément de positionnement (61) comporte un élément de liaison

6. L'unité d'entraînement selon l'une des revendications précédentes, **caractérisée par le fait qu'**un élément de connexion est recouvert d'un matériau non conducteur au moins à certains endroits.

7. L'unité d'entraînement selon l'une des revendications précédentes, **caractérisée par le fait que** le boîtier de commande (7) est fermé sur son côté éloigné du boîtier du stator (5) par un couvercle de boîtier de commande (9).
